## Europäisches Patentamt
## European Patent Office
## Office européen des brevets

(19)

(11) Numéro de publication: **0 042 351**
**B1**

(12)

# FASCICULE DE BREVET EUROPEEN

(45) Date de publication du fascicule du brevet:
**16.07.86**

(51) Int. Cl.⁴: **H 05 K 7/10, H 05 K 13/00**

(21) Numéro de dépôt: **81810037.2**

(22) Date de dépôt: **11.02.81**

(54) **Dispositif de support pour circuit intégré.**

(30) Priorité: **13.06.80 CH 4575/80**

(43) Date de publication de la demande:
**23.12.81 Bulletin 81/51**

(45) Mention de la délivrance du brevet:
**16.07.86 Bulletin 86/29**

(84) Etats contractants désignés:
**AT BE CH DE FR GB IT LI LU NL SE**

(56) Documents cités:
**FR - A - 1 218 609**
**FR - A - 2 195 219**
**US - A - 4 099 615**

(73) Titulaire: **ULTRA- PRECISION S.A., CH-1870 Monthey (Valais) (CH)**

(72) Inventeur: **Birnholz, Jean, c/o Ultra-précision S.A., CH-1870 Monthey / VS (CH)**

(74) Mandataire: **Kirker, Gaylord Emile et al, c/o KIRKER & Cie S.A. 14, Rue du Mont-Blanc Case postale 872, CH-1211 Genève 1 (CH)**

## Description

Dans la fabrication en série d'appareils électroniques on utilise le plus souvent des circuits intégrés qui sont formés d'un bloc qui est constitué de sections parallèles au nombre de 4, 8, 10 ou 12 par exemple, chacune de ces sections étant munie à chacune de ses extrémités d'une broche. Ces broches forment ainsi deux rangées parallèles qui sont destinées à être engagées dans des douilles prévues dans deux dispositifs de support. Ces dispositifs de support sont constitués chacun par une sorte de règle percée de trous dans lesquels les douilles sont disposées. Une difficulté se rencontre toutefois et qui provient du fait que les deux supports en forme de règle doivent être disposés l'un par rapport à l'autre de façon extrêmement précise pour que les broches du circuit intégré pénètrent très exactement dans les douilles des supports, sinon les broches sont endommagées au moment où on cherche à les enfoncer dans les douilles. Ces règles doivent donc être rigoureusement parallèles, de niveau l'une par rapport à l'autre et les douilles d'une des règles doivent être rigoureusement en regard des douilles de l'autre. Toutes ces opérations de mise en place du circuit intégré et de soudure ultérieure des broches dans les douilles se faisant à la machine, dans la façon traditionnelle de procéder, il y a passablement de déchets dus à l'endommagement des broches. La présente invention vise à remédier à cet inconvénient et elle a pour objet un dispositif de support pour circuit intégré formé d'un bloc constitué de sections parallèles munies à chacune de leurs extrémités d'une broche, cette broche formant ainsi deux rangées qui sont destinées à être engagées dans des douilles correspondantes du dispositif de support. Le dispositif selon l'invention est conforme à la revendication 1.

Le dessin annexé représente à titre d'exemple une forme d'exécution du dispositif de support selon l'invention.

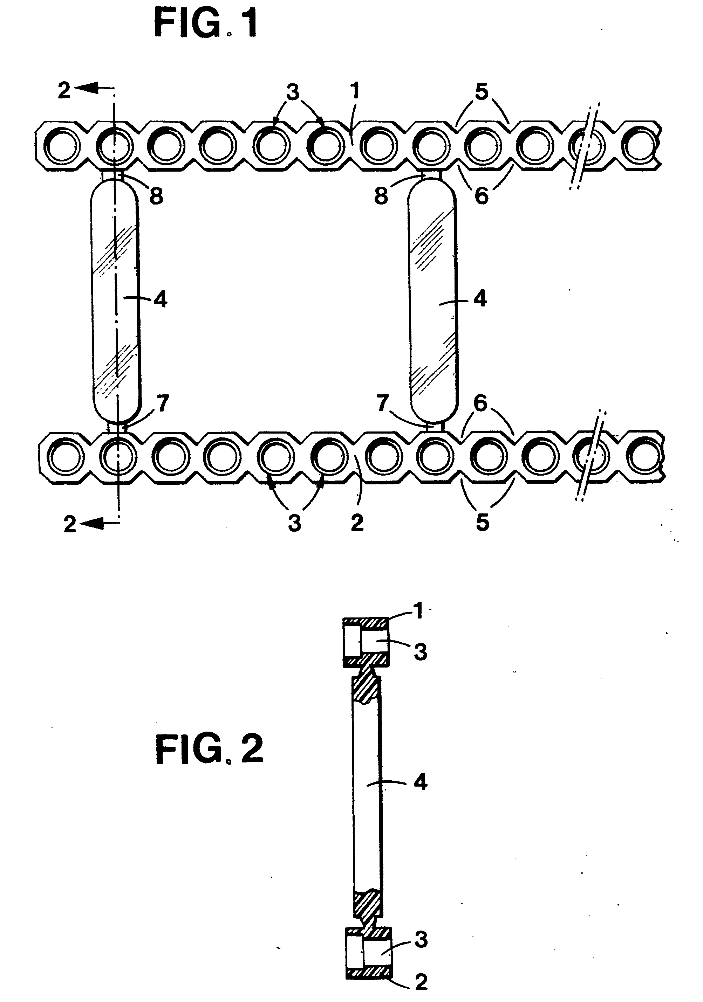

La figure 1 en est une vue en plan d'un dispositif de support conforme à l'invention et la figure 2 une vue en coupe transversale selon la ligne 2–2 de la figure 1.

Le dispositif représenté est formé d'une pièce monobloc constituée par deux parties parallèles 1, 2 où sont pratiqués des trous 3 destinés à recevoir, comme il est connu, des douilles dans lesquelles viennent s'engager les broches du circuit intégré destiné à être fixé sur ce support. Le dispositif comporte en outre des ponts 4 reliant rigidement les deux parties 1 et 2 de façon qu'elles soient maintenues exactement en position correcte l'une par rapport à l'autre.

De cette façon, l'assemblage à la machine du circuit intégré sur le dispositif peut se faire sans problème, de même que le soudage des broches dans les douilles, selon la procédure connue.

Les circuits intégrés sont, comme on l'a mentionné plus haut, formés en général de 4, 8, 10 ou 12 sections par exemple. Pour adapter la longueur du support à la dimension du circuit intégré que l'on désire fixer sur lui, il est prévu le long des parties 1 et 2 des entailles 5, 6 de façon à diminuer la section transversale des parties 1 et 2 entre les endroits où se trouvent les trous 3 destinés à recevoir les douilles. Ainsi, on peut sectionner facilement les parties 1 et 2 pour qu'elles correspondent à la longueur du circuit intégré destiné à venir se placer sur le dispositif de support. De plus, il est prévu à chacune des extrémités des ponts 4, en 7 et 8, une diminution de la section transversale de ces ponts pour permettre de facilement les sectionner à ces endroits et de les enlever une fois que le bloc de circuit intégré est mis en place sur le dispositif. La possibilité d'enlever ainsi les ponts offre l'avantage de libérer complètement l'espace disponible entre les parties 1 et 2, par exemple pour y loger d'autres composants de l'appareil electronique.

## Revendications

1. Dispositif de support pour circuit intégré formé d'un bloc constitué de sections parallèles munies à chacune de leurs extrémités d'une broche, ces broches formant ainsi deux rangées et étant destinées à être engagées dans des douilles correspondantes du dispositif de support, caractérisé en ce qu'il est formé d'une pièce monobloc constituée, d'une part, de deux parties parallèles (1, 2), en matière isolante, présentant des trous (3) pour recevoir les douilles destinées à coopérer avec les broches du bloc de circuit intégré, et, d'autre part, de ponts (4) en matière isolante, reliant rigidement ces deux parties parallèles (1, 2), pour assurer la parfaite coïncidence des centres de deux séries de trous (3) avec les broches du circuit intégré, de façon que les deux séries de douilles disposées dans ces trous (3) coïncident de façon précise avec les broches du circuit intégré, lors de l'opération de mise en place de ce circuit sur le dispositif de support.

2. Dispositif selon la revendication 1, caractérisé en ce que les deux dites parties parallèles (1, 2) ont chacune la forme d'une bande présentant des diminutions de section transversale (5, 6) entre les endroits où sont les douilles successives, pour permettre de sectionner facilement ces bandes à la longueur du bloc de circuit intégré destiné à venir se placer sur le dispositif.

3. Dispositif selon la revendication 2, caractérisé en ce que les ponts (4) présentent des diminutions de section transversale (7, 8) à leurs extrémités, pour permettre de facilement les sectionner à ces endroits, pour les enlever, une fois que le bloc de circuit intégré est mis en place sur le dispositif.

## Claims

1. A support device for an integrated circuit formed of a block comprised of parallel sections provided at each of their ends with a pin, these pins thus forming two rows and being designed for engagement into corresponding sockets of the support device, characterized in that it is formed of a one-block piece comprised of, on the one hand, two parallel parts (1, 2) of an insulating material having holes (3) for receiving the sockets designed to cooperate with the pins of the integrated circuit block, and on the other hand, bridges (4) of an insulating material connecting rigidly these two parallel parts (1, 2) to ensure a perfect coincidence of the centres of the two series of holes (3) with the pins of the integrated circuit, so that the two series of sockets disposed in these holes (3) coincide accurately with the pins of the integrated circuit during the operation of mounting this circuit on the support device.

2. A device according to claim 1, characterized in that said two parallel parts (1, 2) have each the shape of a strip having decreases of the transverse section (5, 6) between the location where the successive sockets are, to permit these strips to be easily cut at the length of the integrated circuit block designed to be placed on the device.

3. A device according to claim 2, characterized in that the bridges (4) have decreases of the transverse section (7, 8) at their ends to permit their easy sectioning at these locations to remove them once the integrated circuit block is mounted on the device.

**Patentansprüche**

1. Sockelvorrichtung für eine integrierte Schaltung, die aus einem Block mit parallelen Abschnitten besteht, wobei jedes der Abschnittsenden einen Stift trägt und diese Stifte somit zwei Reihen bilden und dazu bestimmt sind, in zugehörige Hülsen der Sockelvorrichtung eingesteckt zu werden, dadurch gekennzeichnet, dass sie einstückig aus Isoliermaterial, einerseits aus zwei parallelen gelochten Teilen (1, 2), deren Löcher (3) die Hülsen aufnehmen, in welche die Stifte des Blocks der integrierten Schaltung eingesteckt werden, und andererseits aus Verbindungsteilen (4) gebildet ist, welche die beiden parallelen gelochten Teile (1, 2) steif verbinden, um eine exakte Übereinstimmung der Mittelpunkte der beiden Lochreihen (3) mit den Stiften der integrierten Schaltung zu gewährleisten, wenn diese Schaltung auf die Sockelvorrichtung aufgesetzt wird.

2. Sockelvorrichtung gemäss Anspruch 1, dadurch gekennzeichnet, dass jeder der beiden parallelen gelochten Teile (1, 2) die Gestalt eines Bandes mit Querschnittsverengungen (5, 6) zwischen den Stellen, wo die sich folgenden Hülsen untergebracht sind, aufweist, um diese Bänder leicht auf die Länge des Blocks derjenigen Schaltung, welche auf die Sockelvorrichtung aufgesetzt werden soll, zu kürzen.

3. Sockelvorrichtung gemäss Anspruch 2, dadurch gekennzeichnet, dass die Verbindungsteile (4) an ihren Enden Querschnittsverengungen (7, 8) aufweisen, um an diesen Stellen leicht eine Abtrennung zu erlauben, damit, wenn der Block der integrierten Schaltung auf der Sockelvorrichtung aufgesetzt ist, die Verbindungsteile entfernt werden können.

# FIG. 1

# FIG. 2